(19) Europäisches Patentamt
European Patent Office
Office européen des brevets

(11) **EP 2 256 230 A1**

(12) **EUROPÄISCHE PATENTANMELDUNG**

(43) Veröffentlichungstag:
**01.12.2010 Patentblatt 2010/48**

(21) Anmeldenummer: **09007182.0**

(22) Anmeldetag: **29.05.2009**

(51) Int Cl.:
**C23C 16/16** $^{(2006.01)}$ **C23C 14/22** $^{(2006.01)}$
**C23C 16/42** $^{(2006.01)}$ **C23C 16/44** $^{(2006.01)}$
**C23C 16/448** $^{(2006.01)}$

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**
Benannte Erstreckungsstaaten:
**AL BA RS**

(71) Anmelder: **Grega, Samuel**
**08221 Velky Saris (SK)**

(72) Erfinder: **Grega, Samuel**
**08221 Velky Saris (SK)**

(74) Vertreter: **Jeck, Anton**
**Jeck - Fleck - Herrmann**
**Patentanwälte**
**Klingengasse 2/1**
**71665 Vaihingen/Enz (DE)**

(54) **Verfahren zur Herstellung von W-, Cr-, Mo-Schichten, deren Carbiden, Nitriden, Siliciden, mehrschictigen Strukturen und Verbindungsstrukturen auf festen Substraten und Vorrichtung für deren Herstellung**

(57) Die Erfindung betrifft ein Verfahren zur Herstellung von W-, Cr-, Mo-Schichten und deren Karbiden, Nitriden, Siliziden, mehrschichtigen Strukturen und Verbindungsstrukturen auf festen Substraten mittels Zersetzung derer Carbonyle in Anwesenheit von Kohlenwasserstoff oder Stickstoff oder Siliziumhydrid und/oder von inertem Gas. Auf das feste Substrat wird unter Bedingungen eines Niederdruck-/ Niedertemperaturplasmas durch eines oder mehrere W-, Cr-, Mo-Carbonyle und Carbonyle von inertem Gas und/oder durch Kohlenwasserstoff und/oder $N_2$ und/oder Siliziumhydrid eingewirkt.

UMV SAV     SEI   15.0kV  X150,000   100nm   WD 10.0mm

Fig. 1

**Beschreibung**

**Erfindungsgebiet**

Die Erfindung betrifft ein Verfahren zur Herstellung von W-, Cr-, Mo-Schichten, deren Carbiden, Nitriden, Siliciden, mehrschichtigen Strukturen und Verbindungsstrukturen auf festen Substraten mittels Zersetzung von Carbonylen $W(CO)_6$, $Cr(CO)_6$, $Mo(CO)_6$ unter Bedingungen eines Niederdruck-/Niedertemperaturplasmas und eine Vorrichtung zur Umsetzung dieses Verfahrens.

**Bisheriger Stand der Technik**

Bisherige Verfahren zur Herstellung von W-, Cr-, Mo-Schichten, deren Carbiden, Nitriden, Siliciden, mehrschichtigen Strukturen und Verbindungsstrukturen verwenden verschiedene Abwandlungen von PVD-Methoden (Physical Vapour Deposition/physikalische Gasphasenabscheidung), wie zum Beispiel Magnetron-Zerstäubung/Magnetronsputtering, Lichtbogenverdampfung und Methoden auf Basis direkter Anwendung der Ausgangsmetalle W, Cr, Mo, als auch deren Carbide, Nitride und Silicide.
W-, Cr-, Mo-Karbide, -Nitride und -Silicide werden weiter mittels reaktiver PVD-Methoden (Physical Vapour Deposition) durch Elektronenstrahl- und Lichtbogenverdampfung von Metallen oder Magnetron-Zerstäubung/Magnetronsputtering, und durch Einlassen von Reaktivgas hergestellt, und das bei Entstehung von Carbiden, Kohlenwasserstoff (für gewöhnlich $C_2H_4$ oder $C_2H_2$ oder $CH_4$), bei Entstehung von Stickstoff-Nitriden und bei Entstehung von Silicium-Hybride-Siliciden (für gewöhnlich von Silan - $SiH_4$), hergestellt in allen Fällen oftmals in Verbindung mit Ar, oft auch mit $H_2$.. In letzter Zeit werden auch Verfahren zur Verdampfung oder Zerstäubung in Gegenwart von metallischen und nichtmetallischen Bestandteilen von Carbiden, Nitriden und Siliciden angewendet._ Des Weiteren werden Methoden der Ionenimplantation angewandt, bei denen für gewöhnlich Kohlenstoff-, Stickstoff- oder Silicium-Ionen beschleunigt und in die Oberflächenschicht von W, Cr, Mo implantiert werden. Angewendet werden auch Methoden, bei denen Vakuumeindampfung und Ionenimplantation durch Ionen-Bänder kombiniert werden. Diese Methoden sind unter den Bezeichnungen IBAD (Ion Beam Assisted Deposition) und IBD (Ion Beam Deposition) bekannt.
Der Hauptnachteil dieser Verfahrensweisen zur Herstellung von Schichten besteht in der niedrigen Wachstumsgeschwindigkeit der Schichten, die durch die niedrigen Verdampfungsgeschwindigkeiten oder die niedrigen Geschwindigkeiten der Magnetron-Zerstäubung/Magnetronsputtering bedingt ist. Ein weiterer Nachteil besteht in der hohen Verdampfungstemperatur der Stoffe für die Herstellung von Schichten mittels dieser Verfahren und oftmals auch in der Notwendigkeit einer hohen Temperatur der Unterlagen.
Für die Herstellung von W-, Cr-, Mo-Schichten, deren Carbide, Nitride, Silicide, mehrschichtige Strukturen und Verbindungsstrukturen werden auch verschiedene Abwandlungen der CVD- (Chemical Vapour Deposition) und PECVD- (Plasma Enhanced Chemical Vapour Deposition) Methoden angewendet bei Einsatz von W, Cr, Mo und $NH_3$ oder $C_2H_2$ oder $SiH_4$ Chloriden oder Fluoriden, oftmals im Gemisch mit $H_2$ und Ar, und das bei Einsatz eines Trag- und Verdünnungsgases.
Die größten Nachteile dieser Verfahren bestehen in der Notwendigkeit einer hohen Substrattemperatur, einer niedrigen Wachstumsgeschwindigkeit der Schichten und in der wesentlich begrenzten Regulierung der Struktur und weiterer Schichteigenschaften durch die Parameter ihrer Herstellung. Ein weiterer Nachteil dieser Methoden besteht in der allgemein bekannten Erhöhung der Schichtoberflächenrauhigkeit gegenüber der Ausgangsrauhigkeit der Unterlage. Ein weiterer Nachteil der heutzutage bekannten CVD- und PECVD-Verfahren besteht in der Entstehung von Wasserstoffhalogenen als Abfallprodukt von chemischen und plasmachemischen Reaktionen. Diese Abfallprodukte werden oftmals zusammen mit Ar und Wasserstoff in die wachsende Schicht als Unreinheiten mit eingebaut und sind schwer zu identifizieren. Deren Wirkung auf die gewünschten Nutzeigenschaften der Schichten ist bislang wenig bekannt und fällt in den meisten Fällen negativ aus. Des Weiteren sind Methoden zur Herstellung von Metallschichten mittels thermischer Zersetzung von Metallcarbonylen $W(CO)_6$, $Cr(CO)_6$, $Mo(CO)_6$ und weiterer bekannt, die als Thermal CVD oder Hot Filamemt CVD bezeichnet werden und bei denen das Trägergas Ar, oftmals mit $H_2$, gegebenenfalls mit Ar und CO, ferner mit Zusatz von $NH_3$ und Ar verwendet wird. Auf diese Weise werden Nitridschichten von W, Cr, oder Mo hergestellt, und bei der Herstellung von WC wird Kohlenwasserstoff und Ar dazugegeben. Der Nachteil dieser Verfahren in den bekannten Vorrichtungen besteht in der niedrigen Wachstumsgeschwindigkeit der Schichten und der Notwendigkeit einer hohen Substrattemperatur, damit die gewünschte Qualität der
Oberfläche erreicht werden kann und die Anwesenheit von CO-Molekülen sowie anderer Abfallprodukte in den Schichten verhindert wird

**Wesen der Erfindung**

Nachteile der oben angeführten Verfahren beseitigt das Verfahren zur Herstellung von W-, Cr-, Mo-Schichten, deren Carbiden, Nitriden, Siliciden, mehrschichtigen Strukturen und Verbindungsstrukturen auf einem festen Substrat mittels Zersetzung von W-, Cr- und Mo- Carbonylen in Anwesenheit von Kohlenwasserstoff oder Stickstoff oder Siliciumhydrid, und/oder inertem Gas, dessen Wesen darin besteht, dass das feste Substrat in die Kammer eines der PVD-Vorrichtungstypen angeordnet wird, wobei an diese Kammer über mindestens einen Flansch mindestens eine Vorrichtung gemäß der Erfindung angeschlossen wird, das ein Hineinfließen der Dämpfe von Metallcarbonylen ermöglicht. Auf diese Weise kann man Schichten auf festen Substraten durch die Kombination bekannter PVD-Verfahren mit den Verfahren gemäß der Erfindung herstellen. Die erfindungsgemäßen Verfahren beruhen auf der Zersetzung von Metallcarbonylen auf derartige Weise, so dass auf das feste Substrat unter Bedingungen eines Niederdruck-/ Niedertemperaturplasmas durch eines oder mehrere W-, Cr-, Mo-Carbonyle in Anwesenheit oder Abwesenheit eines inerten Gases und/oder durch Kohlenwasserstoff und/oder $N_2$ und/oder Siliciumhydrid vorzugsweise mit $SiH_4$ eingewirkt wird. In den meisten Fällen handelt es sich bei dem inerten Gas um Ar. Im Falle der Anwendung von mehr als einem Metallcarbonyl werden mehrere Metallcarbonyle gleichzeitig eingelassen oder einzeln in gewünschter Reihenfolge.

Die Abhängigkeit des Dampfdruckes der Metallcarbonyle von der Temperatur wird durch die Gleichungen beschrieben, die hier in identischer Form angeführt sind, wie sie übernommen wurden aus:

D. Chandra, K.H. Laub, W-M. Chien, M. Garner: J. Phys. Chem. Solids, 66, (2005), 241 Raja Chellappa, Dhanesh Chandra: J. Chem. Thermodynamics, 37, (2005), 377 )

$$W(CO)_6 : \quad \lg(p/mmHg) = 10{,}947 - 3640{,}4 \, /T \tag{1}$$

$$Cr(CO)_6 : \quad \lg(p/mmHg) = 11{,}475 - 3622{,}9 \, /T \tag{2}$$

$$Mo(CO)_6 : \quad \lg(p/mmHg) = 11{,}727 - 3788{,}3 \, /T \tag{3}$$

$$Os_3(CO)_{12} : \quad \lg(p/mmHg) = 15{,}667 - 5659{,}5 \, /T \tag{4}$$

$$Re_2(CO)_{10} : \quad \lg(p/mmHg) = 10{,}685 - 4152 \, /T \tag{5}$$

$$Ru_3(CO)_{12} : \quad \lg(p/kPa) = 12.519 - 5392 \, /T \tag{6}$$

$$Rh_6(CO)_{16} : \quad \lg(p/kPa) = 12.553 - 5540 \, /T \tag{7}$$

Die Abhängigkeit des Dampfdruckes der angeführten Metallcarbonyle von ihrer Temperatur ermöglicht es, bei Arbeitsdrucken aus dem Intervall 0,001 Pa bis 1000 Pa hohe Sublimationsgeschwindigkeiten bzw. Verdampfungsgeschwindigkeiten zu erreichen, und somit auch eine hohe Einlassgeschwindigkeit der Carbonyl-Dämpfe in die Vakuumkammer des PVD- Systems, und das ohne die Anwendung eines Trägergases.

Die Schichten auf dem festen Substrat werden in der Kammer der PVD-Vorrichtung derart hergestellt, dass im Bezug auf ihre chemische Zusammensetzung, Struktur, Textur und weitere Eigenschaften das Substrat nach dem Absaugen der Vakuumkammer auf Grenzdruck mittels Inertgasionen-Bombardierung, vorzugsweise Ar, von adsorbierten Schichten aus der Umgebung gereinigt wird,. Gleichzeitig erfolgt eine Erwärmung auf die gewünschte Temperatur, die für das Auftragen der Schichten notwendig ist. Dabei reicht oftmals die Substraterwärmung aus, die durch die Ionenbombardierung erzielt wurde, bei der ein Teil der kinetischen Energie der Inertgasionen auf das Substrat in Form von Wärme übergeht.

Anderenfalls wird für die Erwärmung des Substrates Strahlungswärme oder Wärmeübertragung aus dem Heizkörper verwendet. Im Bedarfsfall wird auf dem Substrat eine Unterlageschicht durch die Anwendung eines der bekannten PVD-Verfahren geformt, die vorzugsweise durch Ti oder Cr gebildet ist. Ferner ist in der Kammer der PVD-Vorrichtung durch das Regulierglied, welches zwischen der Kammer und dem Vakuumsystem angeordnet ist, der Druck eingestellt, für den Fall, dass kein Reaktivgas verwendet wird. Wird ein Reaktivgas verwendet, wird der Druck in der Kammer des PVD-Systems durch das Regulierglied, welches zwischen der Kammer und dem Vakuumsystem angeordnet ist, und durch die Durchflussregulierung des Reaktivgases am entsprechenden Regulierglied eingestellt. Im Falle der Herstellung von Schichten mit Anwendung mehr als eines Reaktivgases werden die Zuflüsse dieser Gase durch die Einstellung des Reguliergliedes, angeordnet zwischen der Kammer und dem Vakuumsystem der PVD- Vorrichtung, und durch die Durchflüsse der Reaktivgase an den Reguliergliedern $M_1$ bis $M_n$ reguliert, und das in Bezug auf den gewünschten Enddruck und die gewünschten Partialdrucke der einzelnen Reaktivgase. Einen Bestandteil der Regulierung bildet auch die Sicherstellung des Verhältnisses der Durchflussmengen der Reaktivgase, auch im Verlaufe des Hineinfließens der Dämpfe von Metallcarbonylen, und das in Bezug auf den gewünschten Gesamtdruck in der Kammer.

In einem weiteren Schritt wird das zwischen der Sublimationskammer und Kammer der PVD- Vorrichtung angeordnete Verschlussventil geöffnet. Die Geschwindigkeit des Hineinfließens der Dämpfe von Metallcarbonylen in die Kammer der PVD-Vorrichtung bei dem gegebenen Gesamtdruck in der Kammer der PVD-Vorrichtung wird durch die Einstellung der Temperatur der Metallcarbonyle mittels ihrer Erwärmung reguliert, und das entweder mittels Strahlungswärme oder mittels Wärmeleitung aus einem Heizkörper oder mittels Wärmeleitung durch die Kammerwand, die Metallcarbonyle aufweist.

Ferner werden in Bezug auf die gewünschten strukturellen und weiteren Eigenschaften der hergestellten Schichten die übrigen Parameter an der PVD-Vorrichtung eingestellt, bei denen die Schicht hergestellt wird, und insbesondere auch die Größe der elektrischen Vorspannung am Strom leitenden Substrathalter und Strombegrenzungen aus der elektrischen Quelle, bei welcher es sich um eine Gleichspannungsquelle, aber hochfrequente Quelle, oder Impulsquelle handelt. Dabei bildet bei der Anwendung einer Gleichspannungsquelle der Substrathalter die Kathode gegenüber der geerdeten Vakuumkammer der PVD-Vorrichtung. Im Falle der Anwendung einer elektrischen Hochfrequenz- oder Impulsquelle können angesichts der gewünschten Struktureigenschaften der Schichten asymmetrische Vorspannungsverläufe genutzt werden. Falls die Parameter der Herstellung von Schichten während ihres Wachstums reguliert werden, ermöglicht es das Verfahren gemäß der Erfindung, Schichten mit gradienter Struktur herzustellen.

Die Zersetzung der Metallcarbonyle erfolgt nach der Gleichung $M(CO)_6 \rightarrow M + 6\ CO$, wobei M W oder Cr oder Mo oder ein weiteres Metall ist, das Carbonyle bildet. Dabei erfolgt diese Zersetzung unter Bedingungen eines Niederdruck-/Niedertemperaturplasmas. Ein Teil der Metallatome und CO-Moleküle geraten in einen Ionisierungs- und Exzitationszustand. Dadurch werden nachfolgende Voraussetzungen für breitere Möglichkeiten geschaffen zur Regulierung von Struktur- und Textureigenschaften der Schichten, ihrer Stöchiometrie bei der Herstellung von Carbid-, Nitrid-, Silicidschichten von W, Cr, Mo wie auch von weiteren Metallen, aus denen die Metallcarbonyle gebildet werden oder bei der Herstellung von Schichten bestehend aus Kompositen und ternären oder quaternären Systemen sowie auch Nanokompositstrukturen vom Typ n-MC/a-C, n-MeC , n-MeC/a-C:H, $n-MN_n/a-C$, $n-MN_n/SiN$. Diese Systeme können eine Zusammensetzung M - X aufweisen, wobei M W, Cr oder Mo ist, und X ist N,C oder Si. Bei einer Zusammensetzung M - $X_i$ - $X_j$, oder $M_i$ - $M_j$ - X sind M, $M_i$, $M_j$ W, Cr oder Mo und X, $X_i$,$X_j$ sind N,C, oder Si. Angesichts dessen, dass die Herstellung von Schichten in der Kammer der PVD-Vorrichtung erfolgt, ist es möglich, das erfindungsgemäße Verfahren mit den bekannten PVD-Verfahren zu kombinieren durch die Zugabe weiterer Metallkomponenten, die zum Beispiel während der Herstellung von Schichten mittels Verdampfung eines weiteren Metalls durch eine Elektronenkanone oder einen Elektronenbogen oder Zerstäubung des Magnetrontargets oder mittels Laserablation gewonnen wurden. Durch die Abwechslung der eingelassenen Carbonyle, oftmals in Kombination mit den Metallatom-Quellen aus dem PVD-System, ermöglicht das Verfahren die Herstellung von Beschichtungen mit einer mehrschichtigen Struktur.

Die Vorteile des Verfahrens gemäß der Erfindung bestehen darin, dass die Herstellung von Schichten basierend auf der Spaltung von Metallcarbonylen unter Plasmabedingungen es ermöglicht, eine hohe Wachstumsgeschwindigkeit der Schichten, hohe Reinheit und Haftfestigkeit zu erreichen. Die Abfallprodukte der Reaktionen bilden CO und $CO_2$, und somit erfordert die Vorrichtung keinen Antikorrosionsschutz. Durch die Parameter, wie etwa Vorspannung, Stromdichte am Substrat, Substrattemperatur, Gesamtdruck und Partialdrucke, können die Schichteneigenschaften in breitem Umfang reguliert werden. Ein weiterer Vorteil besteht in der Kombinationsmöglichkeit des erfindungsgemäßen Verfahrens zur Herstellung von Schichten mit klassischen PVD-Verfahren.

Das Wesen der Vorrichtung zur Herstellung von W-, Cr-, Mo-Schichten, deren Carbiden, Nitriden, Siliciden, mehrschichtigen Strukturen und Verbindungsstrukturen auf festen Substraten, die an die Vakuumkammer der PVD-Vorrichtung direkt oder über ein Zwischenglied angeschlossen wird, wobei es sich beim Zwischenglied um eine Ionenquelle oder eine Ionenquelle und einen Ionentrenner handeln kann, besteht darin, dass sie mindestens eine Vakuumkammer aufweist, welche über ein Vakuumventil an die Vakuumkammer der PVD- Vorrichtung oder über ein Vakuumventil an die Ionenquelle angeschlossen wird. Dabei ist in der Vakuumkammer ein Behälter angeordnet, in den mindestens eines der folgenden Metallcarbonyle $W(CO)_6$, $Cr(CO)_6$, $Mo(CO)_6$, $Re_2(CO)_{10}$, $Ru_3(CO)_{12}$, $Os_3(CO)_{12}$ eingebracht wird.

Ferner ist an die Kammer über ein Vakuumventil und Regulierglied ein Vakuumsaugsystem angeschlossen, welches von dem Vakuumsaugsystem der PVD-Vorrichtung unabhängig ist. Der Behälter der Vorrichtung wird auf die Verdampfungs- oder Sublimationstemperatur von $W(CO)_6$, $Cr(CO)_6$, $Mo(CO)_6$, $Re_2(CO)_{10}$, $Ru_3(CO)_{12}$, $Os_3(CO)_{12}$ erwärmt, und zwar mittels Strahlungswärme oder eines Heizkörpers oder deren Kombination, oder seine Erwärmung oder Kühlung erfolgt mittels Wärmeleitung durch die Kammerwände. An die Kammer mit dem Behälter mit einem oder mehreren Metallcarbonylen sind über Einlass-Regulierglieder Reaktivgas- und Inertgas-Quellen angeschlossen.

Einen Bestandteil der Vorrichtung bildet das Regulier-/Lenkungssystem, welches unter anderem die Verhältnisse zwischen dem Totaldruck in der Kammer der PVD-Vorrichtung, den Partialdrucken der Reaktivgase und des inerten Gases und die Temperatur der Metallcarbonyle regelt.

Der Vorteil der Vorrichtung gemäß der Erfindung besteht darin, dass es die Herstellung von W, Cr, Mo, Os, Rh, Ru, Re - Metallschichten, deren Carbiden, Nitriden, Siliciden, mehrschichtigen Strukturen und Verbindungsstrukturen auf festen Substraten ermöglicht ohne die Entstehung von korrosiven Abfallprodukten, und das auch bei niedrigen Temperaturen der Unterlagen und hoher Wachstumsgeschwindigkeit der Schichten.

Ein weiterer Vorteil der erfindungsgemäßen Vorrichtung besteht in der Erweiterung der Möglichkeiten von PVD-Vorrichtungen und im Falle eines Anschlusses an das PVD-System, direkt oder über eine Ionenquelle mit einem Ionentrenner, in der Erweiterung der Möglichkeiten von IBD- und IBM-Methoden bei der Erzielung hoher Stromdichten in Ionen-Bändern.

Ein Ausführungsbeispiel der Erfindung ist in der Zeichnung schematisch dargestellt. Es zeigen:

Fig. 1 Abbildung der Wolframcarbid-Schichtoberfläche mittels der REM. Zv. 150 000 x Methode

Fig. 2 Abbildung der Bruchfläche der Wolframcarbid-Schicht mittels der REM. Zv. 1000 000 x Methode

Fig. 3 graphische Darstellungen des chemischen Tiefenkonzentrationsprofils der zweischichtigen WC-TiN-Beschichtung auf der Stahlunterlage, gemessen mittels der Auger-Elektronen-Spektroskopie-Methode

Fig. 4 Abbildung der TiC-WC-TiN-Schicht am Körper des Schnellschnittstahl-Bohrers mittels der REM. Zv. 4700 x Methode

Fig. 5 graphische Darstellung der chemischen Elementar-Analyse mittels der EDX- Methode der TiC-WC-TiN-Schicht am Körper des Schnellschnittstahl-Bohrers

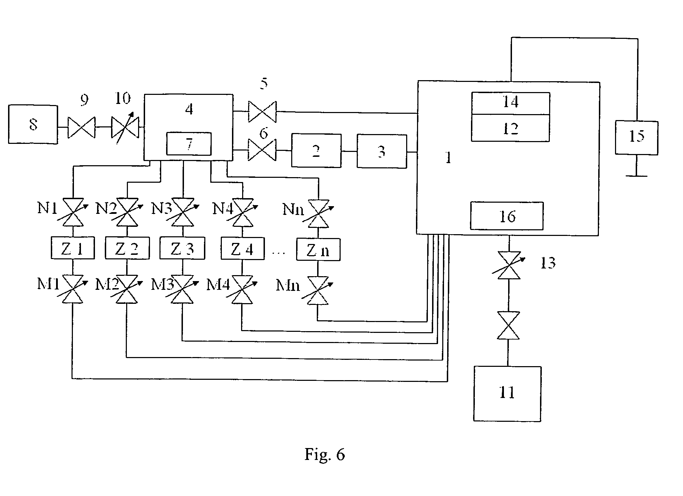

Fig. 6 schematische Darstellung der Vorrichtung zur Herstellung von Schichten.

**Ausführungsbeispiele der Erfindung**

Beispiel Nr.1

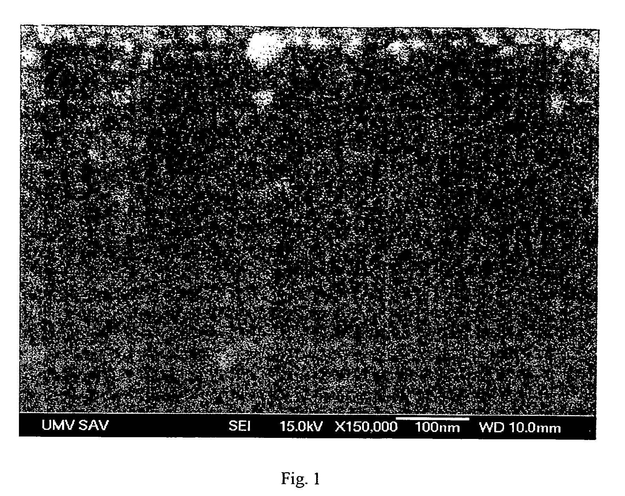

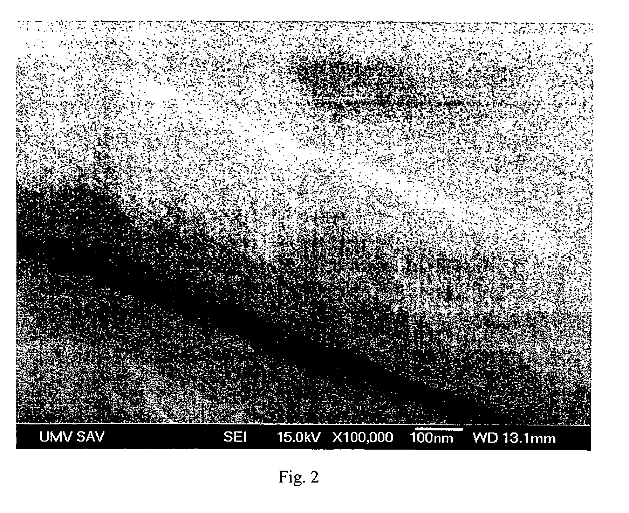

In der Vorrichtung und nach dem Verfahren gemäß der Erfindung wurden Wolframcarbid-Schichten auf Stahl- und Siliciummonokristall-Substraten hergestellt. Die Substrate (12) wurden in einen elektrischen leitenden Halter (14) gelegt. Die Vakuumkammer der PVD-Vorrichtung (1) wurde auf einen Grenzdruck von $2.10^{-3}$ Pa abgesaugt. Anschließend wurde in die Vakuumkammer (1) über ein Regulierglied (M1) Ar eingelassen. Das Einlassen des Ar wurde derart reguliert, dass in der Kammer (1) ein Druck von 8 Pa aufrechterhalten wurde. Die Sauggeschwindigkeit des Vakuumsystems wurde durch ein Regulierglied (13) verringert. An den Halter (14) aus der Quelle (15) wurde gegenüber der geerdeten Vakuumkammer eine elektrische Vorspannung - 4,5 kV angeschlossen. An der elektrischen Quelle (15) wurde die Strombegrenzung derart eingestellt, dass die Stromdichte an der Substratoberfläche bei 1 $mAcm^{-2}$ lag. Die Substrate wurden in der entstandenen Glimmentladung auf die Temperatur von 200° C erwärmt. Anschließend wurde die Ar-Zuleitung geschlossen. Die Kammer (1) wurde auf einen Druck von 0,8 Pa abgesaugt. In den Behälter (7) in der Kammer (4) wurde Wolframhexacarbonyl eingebracht. Die Vakuumkammer (4) wurde durch das Vakuumsystem (8) über das Vakuumventil (9) und das Regulierelement (10) auf einen mit dem in der Kammer (1) identischen Druck abgesaugt. Danach wurde das Vakuumventil (5) geöffnet. An den Halter (14) aus der Quelle (15) wurde gegenüber der geerdeten Vakuumkammer mit Strombegrenzung eine elektrische Vorspannung - 4,5 kV so angeschlossen, dass die Stromdichte an der Substratoberfläche bei 1,2 $mAcm^{-2}$ lag. In dem beschriebenen Verfahren wurden Wolframcarbid-Schichten mit feinkörniger Struktur und niedriger Rauhigkeit hergestellt, was in der beigelegten Abbildung in Fig. 1 und in der beigelegten Abbildung in Fig. 2 dokumentiert wird. Auf den Schichten wurde eine Mikrohärte von 20 GPa gemessen. Wegen der beinahe identischen Eigenschaften der Mo- und Cr-Carbonyle wurden auf die gleiche Weise auch Molybdäncarbid- und Chromcarbid-Schichten hergestellt.

Beispiel Nr. 2

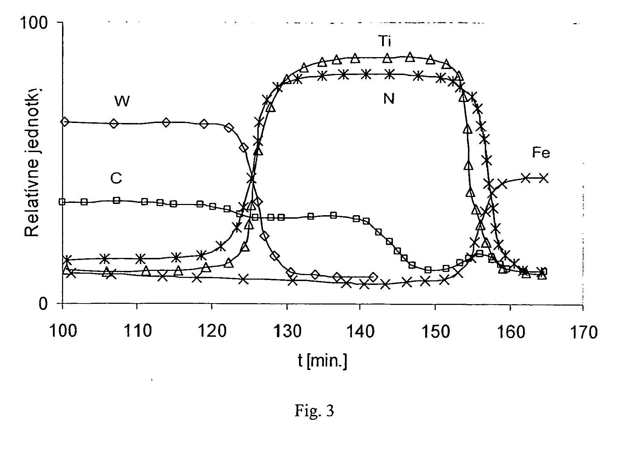

Die Stahlsubstrate wurden in der Kammer (1) auf eine Temperatur von 450° C erwärmt, auf die gleiche Weise wie in Beispiel Nr. 1 beschrieben. Anschließend wurde die TiN-Schicht im reaktiven Verfahren mittels der EB-PVD-Methode hergestellt. Danach wurde die Wolframcarbid-Schicht auf dem Substrat mit der TiN-Schicht auf die gleiche Weise wie in Beispiel Nr. 1 in Anwesenheit von $C_2H_2$ hergestellt. Dieses wurde in die Kammer (1) über ein Regulierelement (M3) so eingelassen wurde, dass der Gesamtdruck in der Kammer (1) bei 8 Pa lag. Unter solchen Bedingungen wurde eine zweischichtige WC-TiN-Beschichtung hergestellt mit einem fließenden Übergang der Ti- und W-Konzentration in der Zwischenschicht. Dokumentiert wird dies in der beiliegenden Abbildung auf Fig. 3 durch das chemische Tiefenkonzentrationsprofil, gemessen mittels der Auger-Elektronen-Spektroskopie-Methode (AES),

Beispiel Nr. 3

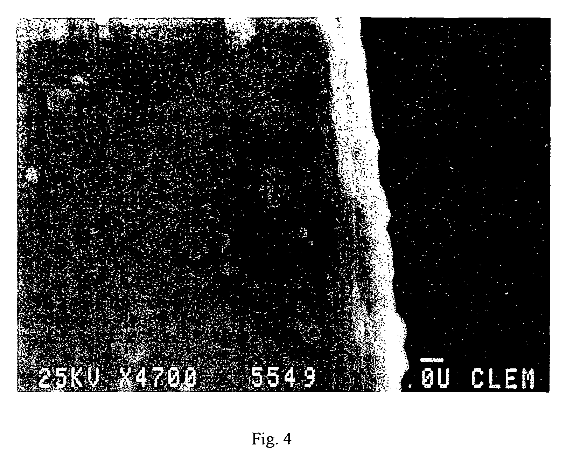

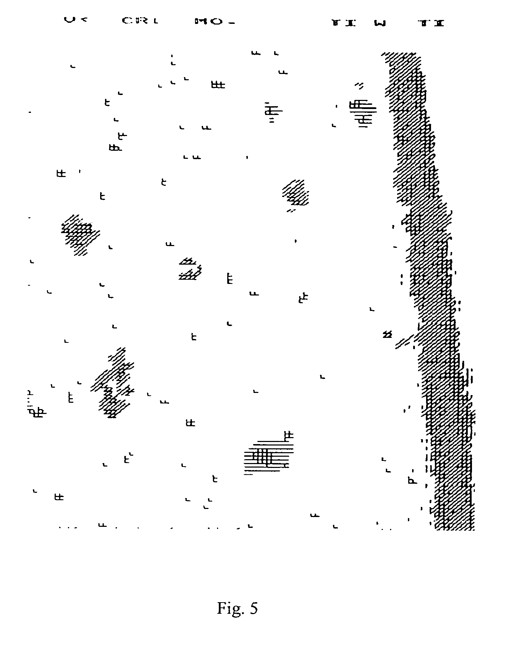

Geräte aus Schnellschnittstahl wurden im Halter (14) in der Kammer (1) befestigt. Dieser führte während der Herstellung von Schichten eine rotierende Planetenbewegung aus. Die Geräte wurden auf eine Temperatur von 550° C erwärmt, auf die gleiche Weise wie in Beispiel Nr. 1 beschrieben. Anschließend wurde die TiC-Schicht im reaktiven Verfahren mit Befüllung von $C_2H_2$ mittels der EB-PVD-Methode hergestellt. Danach wurde auf die gleiche Weise wie in Beispiel Nr. 1 eine Wolframcarbid-Schicht in Anwesenheit von $C_2H_2$ hergestellt, das in die Kammer (1) über ein Regulierelement (M3) so eingelassen wurde, dass der Gesamtdruck in der Kammer (1) bei 2 Pa lag. Anschließend wurde die TiN-Schicht im reaktiven Verfahren mittels der EB-PVD-Methode hergestellt. Die Mikrohärte bei einer derartig hergestellten dreischichtigen TiC-WC-TiN-Beschichtung betrug 28 GPa. In der beiliegenden Abbildung in Fig. 4 ist eine hergestellte Beschichtung am Bohrerkörper dokumentiert. In der beiliegenden Abbildung in Fig. 5 ist eine chemische Element-Flächenanalyse der TiC-WC-TiN-Beschichtung am Bohrerkörper, durchgeführt mittels der EDX-Methode, dargestellt.

Beispiel Nr. 4

In der Vorrichtung und nach dem Verfahren gemäß der Erfindung wurden auf den Stahl- und Siliciummonokristall-Substraten Schichten des ternären Systems W-Cr-C hergestellt. Die Substrate wurden in der Kammer (1) auf eine Temperatur von 250° C erwärmt, auf die gleiche Weise wie in Beispiel Nr. 1 beschrieben. In den Behälter (7) in der Kammer (4) wurde Wolframhexacarbonyl und Chromhexacarbonyl im Gewichtsverhältnis von 2,65 : 1,8 eingebracht. Die weitere Vorgehensweise war dieselbe wie in Beispiel Nr. 1. Die chemische Zusammensetzung der Schicht, gemessen mittels der Element-Flächenanalyse, lag bei 33% W, 25% Cr, 42 % C.

Beispiel Nr. 5

Das Substrat in Form von monokristallinem Si wurde in der Kammer (1) auf eine Temperatur von 200° C erwärmt, auf die gleiche Weise wie in Beispiel Nr. 1 beschrieben. Nach Beendigung der Erwärmung wurde die Kammer (1) durch das Vakuumsystem (11) auf den Druck von $2.10^{-3}$ Pa abgesaugt. Anschließend wurde über das Regulierglied (M1) aus dem Speicher (Z1) Ar in die Kammer (1) so eingelassen, dass der Gesamtdruck in der Kammer 0,05 Pa betrug. Nach Einbringen des Molybdänhexacarbonyls in den Behälter (7) in der Kammer (4) wurde die Kammer (4) über das Vakuumventil (9) und Regulierglied (10) auf den Druck von 0,05 Pa abgesaugt. Nachdem das Vakuumventil (9) geschlossen wurde, wurde das Vakuumventil (5) geöffnet. Gegenüber der geerdeten Vakuumkammer wurde am Substrathalter eine elektrische Vorspannung - 5 kV eingestellt. Eine derartig hergestellte Schicht wies einen spezifischen Widerstand auf, der mittels der 4-Punkt-Methode mit 128 $\mu\Omega$.cm gemessen wurde. An der Schnittstelle zwischen der Schicht und dem Substrat wurde eine Molybdänsilicid-Zwischenschicht identifiziert.

Beispiel Nr. 6

Die schematische Ausführung der allgemeinen Lösung der Vorrichtung gemäß der Erfindung besteht aus einer Vakuumkammer (4), in der eine Kammer (7) angeordnet ist. Die Kammer (4) ist über ein Vakuumventil (5) an die Vakuumkammer der PVD-Vorrichtung (1) angeschlossen. An die Vakuumkammer (4) ist über ein Regulierglied (10) und ein Vakuumventil (9) ein Hoch- oder Ultrahochvakuumsystem (8) angeschlossen. Ferner sind an die Vakuumkammer (4) über ein Regulierglied (N1) Zuleitungen des inerten Gases aus dem Speicher (Z1) und über die Regulierglieder (N2) bis ($N_n$) Zuleitungen der Reaktivgase , und das jedes einzeln, aus den Speichern (Z2) bis ($Z_n$) angeschlossen. Die Vorrichtung gemäß der Erfindung ist über ein Vakuumventil (5) an die Kammer (1) der PVD-Vorrichtung angeschlossen. Die Regulierelemente (M1) bis ($M_n$) sind Bestandteil der PVD-Vorrichtung.

Beispiel Nr. 7

Die schematische Ausführung der allgemeinen Lösung der Vorrichtung gemäß der Erfindung ist dieselbe wie in Beispiel Nr. 6, wobei an die Kammer (1) der PVD-Vorrichtung über ein Vakuumventil (5) eine Ionenquelle (2) und ein

Ionentrenner (3) angeschlossen sind.

Beispiel Nr. 8

Eine konkrete Lösung der allgemeinen Ausführung der Vorrichtung gemäß der Erfindung, übereinstimmend mit den Beispielen Nr. 1 bis Nr. 5, besteht aus einer Vakuumkammer (4), in der eine Kammer (7) angeordnet ist. Die Kammer (4) ist über ein Vakuumventil (5) an die Vakuumkammer der PVD-Vorrichtung (1) angeschlossen. An die Vakuumkammer (4) ist über ein Regulierglied (10) und ein Vakuumventil (9) ein Hochvakuumsystem (8) angeschlossen, bestehend aus einer Rotations- und Diffusionsluftpumpe. Ferner sind über ein Regulierglied (M1) Ar-Zuleitungen aus dem Speicher (Z1) und über Regulierglieder (M2) Zuleitungen für Reaktivgas $C_2H_2$ aus den Speichern (Z2) an die Vakuumkammer (4) angeschlossen. Diese Ausführung der Vorrichtung ist über ein Vakuumventil (5) an die Kammer (1) der PVD-Vorrichtung angeschlossen. Die Regulierelemente (M1) und ($M_2$) sind Bestandteil der PVD-Vorrichtung, die eine Hochspannungs-Elektronenkanone (16), ein Hochvakuumsystem (11), ein Regulierglied (13) und eine elektrische Gleich-Hochspannungsquelle (15) umfasst.

**Industrielle Verwertbarkeit.**

W-, Cr-, Mo-, Os-, Rh-, Ru-, Re-Schichten, deren Carbide, Nitride, Silicide, Boride, mehrschichtige Strukturen und Verbindungsstrukturen auf festen Substraten, hergestellt gemäß der Erfindung in der Vorrichtung gemäß der Erfindung, haben wegen ihrer spezifischen physikalischen, chemischen und mechanischen Eigenschaften aus der Anwendungssicht ein großes Potenzial.

Angesichts ihrer hohen Härten, hohen Widerstandsfähigkeit gegen Abnutzung, hohen Schmelztemperatur, chemischen Widerstandsfähigkeit, Widerstandsfähigkeit gegen Korrosion, relativ hohen elektrischen Leitfähigkeit und katalytischen Eigenschaften liegt deren industrielle Verwertbarkeit in Bereichen des Schutzes von Geräten und tribologischen Knoten vor Abnutzung und der Bildung von elektrischen leitenden Antidiffusions-Barrieren. Einige Schichten wie zum Beispiel Wolfram-Carbidschichten auf Werkstoffen aus Kohlefaser sind als Katalysatoren geeignet.

**Patentansprüche**

1. Verfahren zur Herstellung von W-, Cr-, Mo-Schichten und deren Karbiden, Nitriden, Siliziden, mehrschichtigen Strukturen und Verbindungsstrukturen auf festen Substraten mittels Zersetzung derer Carbonyle in Anwesenheit von Kohlenwasserstoff oder Stickstoff oder Siliziumhydrid und/oder von inertem Gas,
**dadurch gekennzeichnet, dass** auf das feste Substrat unter Bedingungen eines Niederdruck-/ Niedertemperaturplasmas durch eines oder mehrere W-, Cr-, Mo-Carbonyle und Carbonyle von inertem Gas und/oder durch Kohlenwasserstoff und/oder $N_2$ und/oder Siliziumhydrid eingewirkt wird.

2. Verfahren nach Anspruch 1, **dadurch gekennzeichnet, dass** auf das Substrat mit Dämpfen eines oder mehrerer W-, Cr-, Mo-Carbonyle stufenweise oder gleichzeitig eingewirkt wird.

3. Verfahren nach Anspruch 1 bis 2, **dadurch gekennzeichnet, dass** die W-, Cr-, Mo- Schichten ohne Anwesenheit von inertem Gas oder bei Anwesenheit eines inerten Gases mit einem Durchfluss im Interval 1 $cm^3.min^{-1}$ bis 500 $cm^3.min^{-1}$ hergestellt werden.

4. Verfahren nach Anspruch 1 bis 2, **dadurch gekennzeichnet, dass** die W-, Cr-, Mo- Nitridschichten in Anwesenheit von $N_2$ oder eines Gemisches von $N_2$ und eines inerten Gases hergestellt werden.

5. Verfahren nach Anspruch 1 bis 2, **dadurch gekennzeichnet, dass** die W-, Cr-und Mo- Carbidschichten in Anwesenheit von $C_2H_2$ oder $C_2H_4$ oder in Anwesenheit eines Gemisches von $C_2H_2$ oder $C_2H_4$ und eines inerten Gases hergestellt werden.

6. Verfahren nach Anspruch 1 bis 2, **dadurch gekennzeichnet, dass** die W-, Cr-, Mo- Silicidschichten in Anwesenheit von $SiH_4$ oder $Si_2H_6$ oder in Anwesenheit eines Gemisches von $SiH_4$ oder $Si_2H_6$ und eines inerten Gases hergestellt werden.

7. Verfahren nach Anspruch 1 bis 6, **dadurch gekennzeichnet, dass** als inertes Gas He oder Ne oder Ar oder Xe verwendet wird.

8.  Verfahren nach Anspruch 1 bis 7, **dadurch gekennzeichnet, dass** das feste Substrat in einem elektrischen leitenden Halter angeordnet ist, welcher die Kathode in der Vakuumkammer der PVD-Vorrichtung bildet.

9.  Verfahren nach Anspruch 1 bis 8, **dadurch gekennzeichnet, dass** der Substrathalter an Gleichvorspannung oder Hochfrequenz-Vorspannung oder asymmetrische Hochfrequenz-Vorspannung oder elektrische Impulsvorspannung angeschlossen wird.

10. Verfahren nach Anspruch 1 bis 9, **dadurch gekennzeichnet, dass** sich die elektrische Vorspannung auf dem elektrischen leitenden Halter gegenüber der Erdung der Vakuumkammer im Intervall -10 V bis -10 kV befindet.

11. Verfahren nach Anspruch 1 bis 10, **dadurch gekennzeichnet, dass** sich die Stromdichte am Substrat im Intervall $0,01$ mA.cm$^2$ bis $100$ mA.cm$^2$ befindet.

12. Verfahren nach Anspruch 1 bis 11, **dadurch gekennzeichnet, dass** der elektrische leitende_Halter eine Rotationsbewegung oder eine rotierende Translationsbewegung durchführen kann.

13. Verfahren nach Anspruch 1 bis 12 **dadurch gekennzeichnet, dass** das Substrat vor dem Auftragen der ersten Schicht durch Ionenbombardierung gereinigt wird.

14. Verfahren nach Anspruch 1 bis 12, **dadurch gekennzeichnet, dass** das feste Substrat vor dem Auftragen der Schichten auf eine Temperatur von mindestens 160°C erwärmt wird.

15. Verfahren nach Anspruch 1 bis 14, **dadurch gekennzeichnet, dass** das Substrat durch Wärmeleitung aus dem Halter und/oder durch Strahlungswärme und/oder durch Ionenbombardierung bei der Entladung in dem inerten Gas erwärmt wird.

16. Verfahren nach Anspruch 1 bis 15, **dadurch gekennzeichnet, dass** die Herstellung von Schichten bei einem Gesamtdruck in der Vakuumkammer im Intervall $0,005$ Pa bis $1000$ Pa erfolgt.

17. Verfahren nach Anspruch 1 bis 16, **dadurch gekennzeichnet, dass** man es in Kombination mit weiteren Schichten verwenden kann, die mittels PVD-Methoden hergestellt werden.

18. Verfahren nach Anspruch 1 bis 17, **dadurch gekennzeichnet, dass** für die Herstellung von Schichten $W(CO)_6$, $Cr(CO)_6$, $Mo(CO)_6$, $Re_2(CO)_{10}$, $Ru_3(CO)_{12}$. $Os_3(CO)_{12}$ verwendet wird

19. Verfahren nach Anspruch 1 bis 3 und 7 bis 18, **dadurch gekennzeichnet, dass** für die Herstellung von M-B-C-Schichten, wobei es sich bei M um W, Cr, Mo, Re, Ru, $Os_3$ handelt, $B(C_2H_5)_3$ und/oder $B(C_2H_5)_3$ und ein inertes Gas verwendet wird.

20. Vorrichtung zur Herstellung von W-, Cr-, Mo-Schichten, deren Carbiden, Nitriden, Siliciden, mehrschichtigen Strukturen und Verbindungsstrukturen auf festen Substraten, die an die Vakuumkammer der PVD-Vorrichtung (1) direkt oder über ein Zwischenglied angeschlossen wird, wobei es sich beim Zwischenglied um eine Ionenquelle (2) oder eine Ionenquelle (2) und einen Ionentrenner (3) handeln kann, **dadurch gekennzeichnet, dass** sie mindestens aus einer Vakuumkammer (4) besteht, welche über ein Vakuumventil (5) an die Vakuumkammer der PVD-Vorrichtung (1) oder über ein Vakuumventil (6) an die Ionenquelle (2) angeschlossen wird, wobei in der Vakuumkammer (4) ein Behälter (7) angeordnet ist, in den mindestens eines der $W(CO)_6$, $Cr(CO)_6$, $Mo(CO)_6$, $Re_2(CO)_{10}$, $Ru_3(CO)_{12}$, $Os_3(CO)_{12}$ eingebracht wird.

21. Vorrichtung nach Anspruch 20, **dadurch gekennzeichnet, dass** an die Kammer (4) über ein Vakuumventil (9) und Regulierglied (10) ein Vakuumsystem (8) angeschlossen ist.

22. Vorrichtung nach Anspruch 20 und 21, **dadurch gekennzeichnet, dass** der Behälter (7) auf die Verdampfungs- oder Sublimationstemperatur von $W(CO)_6$, $Cr(CO)_6$, $Mo(CO)_6$, $Re_2(CO)_{10}$, $Ru_3(CO)_{12}$, $Os_3(CO)_{12}$ erwärmt wird, vorzugsweise mittels Strahlungswärme oder eines Heizkörpers oder deren Kombination, oder die Erwärmung oder Kühlung erfolgt mittels Wärmeleitung durch die Kammerwände.

23. Vorrichtung nach Anspruch 20 bis 22, **dadurch gekennzeichnet, dass** die Kammer (7) mittels Wärmeleitung durch die Kammerwände erwärmt oder gekühlt ist.

**24.** Vorrichtung nach Anspruch 20 bis 23, **dadurch gekennzeichnet, dass** in die Kammer (1) und Kammer (4) über Einlass-Regulierglieder $(M_1)$, $(M_2)$, ... $(M_n)$ und $(N_1)$, $(N_2)$, ... $(N)_n$. Reaktivgas- und Inertgasquellen $(Z_1)$, $(Z_2)$, ... $(Z_n)$ angeschlossen sind.

Fig. 1

UMV SAV          SEI     15.0kV   X100,000   100nm   WD 13.1mm

Fig. 2

Fig. 3

25KV X4700 5549 .0U CLEM

Fig. 4

Fig. 5

Fig. 6

Europäisches
Patentamt

European
Patent Office

Office européen
des brevets

**EUROPÄISCHER RECHERCHENBERICHT**

Nummer der Anmeldung

EP 09 00 7182

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | SUHR H ET AL: "Plasma reaction of group VI metal carbonyls" PLASMA CHEMISTRY AND PLASMA PROCESSING USA, Bd. 12, Nr. 2, Juni 1992 (1992-06), Seiten 147-159, XP002546614 ISSN: 0272-4324 | 1,3,7, 13-18 | INV. C23C16/16 C23C14/22 C23C16/42 C23C16/44 C23C16/448 |
| Y | * Seite 148 - Seite 158 * | 5-6,19 | |
| X | US 2005/221000 A1 (IKEDA TARO [JP] ET AL) 6. Oktober 2005 (2005-10-06) * Absätze [0051], [0052] * | 1-3,7, 13-18 | |
| Y | SUN Y -M ET AL: "Low temperature tungsten, tungsten carbide and tantalum carbide film growth" GROWTH, EVOLUTION AND PROPERTIES OF SURFACES, THIN FILMS AND SELF-ORGANIZED STRUCTURES. SYMPOSIUM (MATER.RES. SOC. SYMPOSIUM PROCEEDINGS VOL.648) MATER. RES. SOC WARRENDALE, PA, USA, 2001, Seiten P6.43.1-6, XP002546615 * Seite P6.43.3 * | 5 | |
| X | US 2007/235319 A1 (CERIO FRANK M JR [US]) 11. Oktober 2007 (2007-10-11) * Absätze [0053], [0075]; Ansprüche 1-3,8-9 * | 1-2,4, 8-11 | RECHERCHIERTE SACHGEBIETE (IPC) C23C |
| X | EP 1 593 752 A2 (UNITED TECHNOLOGIES CORP [US]) 9. November 2005 (2005-11-09) * Absätze [0009], [0023]; Abbildung 1 * | 1,8,12, 17 | |
| X | US 2003/232138 A1 (TUOMINEN MARKO [FI] ET AL) 18. Dezember 2003 (2003-12-18) * Abbildungen 1a,1b,7 * | 20-24 | |

-/--

Der vorliegende Recherchenbericht wurde für alle Patentansprüche erstellt

| Recherchenort | Abschlußdatum der Recherche | Prüfer |
|---|---|---|
| Den Haag | 5. Februar 2010 | Schuhmacher, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 09 00 7182

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | AKITMOTO K ET AL: "FORMATION OF WXSI1-X BY PLASMA CHEMICAL VAPOR DEPOSITION" APPLIED PHYSICS LETTERS, AIP, AMERICAN INSTITUTE OF PHYSICS, MELVILLE, NY, US, Bd. 39, Nr. 5, 1. September 1981 (1981-09-01), Seiten 445-447, XP000816262 ISSN: 0003-6951 * Seite 445 * ----- | 6 | |
| Y | US 2009/085130 A1 (SUZUKI KENJI [US] ET AL) 2. April 2009 (2009-04-02) * Ansprüche 1,3,4 * ----- | 6 | |
| Y | LACKEY W J ET AL: "Chemical vapor deposition of boron-carbon films using organometallic reagents" MATERIALS LETTERS, NORTH HOLLAND PUBLISHING COMPANY. AMSTERDAM, NL, Bd. 27, Nr. 6, 1. August 1996 (1996-08-01) , Seiten 327-332, XP004078283 ISSN: 0167-577X * Seite 327, rechte Spalte, Zeile 12 * * Seite 331, rechte Spalte, Zeile 25 - Zeile 27 * ----- | 19 | RECHERCHIERTE SACHGEBIETE (IPC) |
| A | US 2007/181421 A1 (WEI HUNG-WEN [TW] ET AL) 9. August 2007 (2007-08-09) * Abbildung 8 * ----- | 20 | |
| A | US 2006/130757 A1 (LI YICHENG [US]) 22. Juni 2006 (2006-06-22) * Ansprüche 3,8,11 * ----- | 20 | |
| A | WO 86/06104 A1 (CENTRE NAT RECH SCIENT [FR]) 23. Oktober 1986 (1986-10-23) * Abbildungen 1-2 * ----- | 20 | |

Der vorliegende Recherchenbericht wurde für alle Patentansprüche erstellt

| Recherchenort | Abschlußdatum der Recherche | Prüfer |
|---|---|---|
| Den Haag | 5. Februar 2010 | Schuhmacher, Jörg |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

 ......................................................................
& : Mitglied der gleichen Patentfamilie, übereinstimmendes
   Dokument

EPO FORM 1503 03.82 (P04C03)

Europäisches
Patentamt

European
Patent Office

Office européen
des brevets

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☒ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

**Europäisches Patentamt**
**European Patent Office**
**Office européen des brevets**

**MANGELNDE EINHEITLICHKEIT**
**DER ERFINDUNG**
**ERGÄNZUNGSBLATT B**

**Nummer der Anmeldung**

EP 09 00 7182

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 2-3, 5, 7, 13-18(vollständig); 1(teilweise)

   Verfahren zum Herstellen von Schichten von Karbiden von W-, Cr, Mo, wie in Anspruch 1 angegeben.
   ---

2. Ansprüche: (1 teilweise) , 4

   Verfahren zum Herstellen von Schichten von Nitriden von W-, Cr, Mo, wie in Anspruch 1 angegeben.
   ---

3. Ansprüche: (1 teilweise), 6

   Verfahren zum Herstellen von Schichten von Siliziden von W-, Cr, Mo, wie in Anspruch 1 angegeben.
   ---

4. Ansprüche: 8-12

   Verfahren zur Herstellung von W-, Cr-, Mo-Schichten und deren Karbiden, Nitriden, Siliziden, mit bestimmten Eigenschaften der Verfahrensführung am Substrathalter, wie in diesen Ansprüchen angegeben.
   ---

5. Anspruch: 19

   Verfahren zum Herstellen von W-, Cr-, Mo-, Re-, Ru-, oder Os-B-C Schichten unter Verwendung von B(C2H5)3 wie in Anspruch 19 angegeben.
   ---

6. Ansprüche: 20-24

   Vorrichtung mit einer PVD-Vorrichtung, und einer Vakuumkammer mit Behälter, angeordnet, wie in Anspruch 20 angegeben.
   ---

**ANHANG ZUM EUROPÄISCHEN RECHERCHENBERICHT
ÜBER DIE EUROPÄISCHE PATENTANMELDUNG NR.**

EP 09 00 7182

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-02-2010

| Im Recherchenbericht angeführtes Patentdokument | Datum der Veröffentlichung | Mitglied(er) der Patentfamilie | Datum der Veröffentlichung |
|---|---|---|---|
| US 2005221000 A1 | 06-10-2005 | CN 1906325 A<br>EP 1733069 A1<br>JP 2007530797 T<br>KR 20070000436 A<br>WO 2005103323 A1 | 31-01-2007<br>20-12-2006<br>01-11-2007<br>02-01-2007<br>03-11-2005 |
| US 2007235319 A1 | 11-10-2007 | KEINE | |
| EP 1593752 A2 | 09-11-2005 | CN 1693534 A<br>JP 2005320632 A<br>KR 20060047370 A<br>US 2005249888 A1 | 09-11-2005<br>17-11-2005<br>18-05-2006<br>10-11-2005 |
| US 2003232138 A1 | 18-12-2003 | US 2008274276 A1 | 06-11-2008 |
| US 2009085130 A1 | 02-04-2009 | CN 1914736 A<br>JP 2005217176 A<br>WO 2005074034 A1<br>KR 20060123552 A | 14-02-2007<br>11-08-2005<br>11-08-2005<br>01-12-2006 |
| US 2007181421 A1 | 09-08-2007 | KEINE | |
| US 2006130757 A1 | 22-06-2006 | KEINE | |
| WO 8606104 A1 | 23-10-1986 | EP 0218623 A1<br>FR 2580670 A1 | 22-04-1987<br>24-10-1986 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **D. Chandra ; K.H. Laub ; W-M. Chien ; M. Garner.** *J. Phys. Chem. Solids,* 2005, vol. 66, 241

- **Raja Chellappa ; Dhanesh Chandra.** *J. Chem. Thermodynamics,* 2005, vol. 37, 377